# EUROPEAN PATENT APPLICATION

(11) **EP 3 348 974 A1**
(43) Date of publication of application: **18.07.2018**
(21) Application number: 17151830.1
(22) Date of filing: 17.01.2017
(51) Int. Cl.: G01J 3/36, G01J 3/28

(54) **AN IMAGE SENSOR, AN IMAGING DEVICE, AN IMAGING SYSTEM AND A METHOD FOR SPECTRAL IMAGING**

(71) Applicant: IMEC vzw, 3001 Leuven (BE)
(72) Inventor: TACK, Nicolaas, 3001 Leuven (BE); LAMBRECHTS, Andy, 3001 Leuven (BE); JAYAPALA, Murali, 3001 Leuven (BE); GEELEN, Bert, 3001 Leuven (BE)
(74) Representative: AWA Sweden AB

(57) **Abstract**

The present invention relates to an image sensor for spectral imaging, said image sensor (100) comprising: an array (102) of light-detecting elements (104); and at least one filter arrangement (108) being arranged on the array (102) for defining a plurality of separate sensor blocks (106) comprising at least: a first mosaic block (106a) associated with a first mosaic filter (1 08a) and comprising a first plurality of rows of the array (102) to acquire a first sub-image in two spatial dimensions, wherein image points in the first sub-image has a spectral resolution defined by unique wavelength bands detected in sub-groups of the light-detecting elements; and a second block (1 06b) comprising a second plurality of rows of the array (102) to acquire a second sub-image in two spatial dimensions wherein each image point in the second sub-image corresponds to a single light-detecting element (104).

## Description

### Technical Field

The present invention relates to an image sensor, an imaging device, an imaging system and a method for spectral imaging. In particular, the present invention relates to scanning of an object in relation to an image sensor.

### Background

Spectral imaging implies that spectral content of an image of an object is extracted and incident light on an image sensor relating to multiple ranges of wavelengths is detected. The spectral imaging may for instance be used in analysis of imaged objects, such as for determination whether a substance having a specific spectral profile is present in the object.

The terms multi-spectral imaging and hyperspectral imaging are often used. These terms do not have established definitions, but typically multi-spectral imaging refers to spectral imaging using a plurality of discrete wavelength bands, whereas hyperspectral imaging refers to imaging narrow spectral wavelength bands over a continuous spectral range. Hyperspectral imaging may also often use a larger number of spectral bands than what is used in multi-spectral imaging.

It is commonly desired that spectral imaging is performed for each part of an object to be imaged. Thus, image data may need to be gathered in three dimensions, two spatial dimensions combined with a spectral dimension. This implies that large amounts of image data need to be gathered and sets requirements on an imaging device for gathering the image data.

The image sensor may comprise an array of light-detecting elements, which may detect an intensity of light incident on the light-detecting elements. The image sensor may further comprise one or more filters for controlling a wavelength being transmitted to the light-detecting element.

There are a number of different ways of gathering image data in three dimensions. The image sensor may be arranged to gather image data in three dimensions (two spatial dimensions and a spectral dimension) in a single exposure. This may be achieved by the image sensor having a mosaic configuration, wherein the image sensor is divided into sub-groups of light-detecting elements repeated over an array of light-detecting elements and wherein a filter is provided such that a plurality of unique wavelength bands is transmitted to the light-detecting elements in the sub-group. Thus, each image point (made up by a single sub-group) has a spectral resolution defined by the wavelength bands detected in the sub-group.

An imaging system may alternatively comprise an optical duplicator, which is arranged to duplicate an image of an object onto several different portions of the image sensor. The image sensor may then comprise a tiled configuration, wherein each tile defines a group of light-detecting elements and the light-detecting elements of a group are arranged to detect a unique wavelength band. Thus, each tile may acquire an image of the object in a unique wavelength band and the spectral resolution of the image sensor is defined by the wavelength bands of the different groups.

An imaging system may alternatively be arranged to scan image information in relation to the light-detecting elements for acquiring image data in three dimensions. For instance, an image of an object may be scanned over lines of the light-detecting elements of the imaging sensor. Each line may be arranged to detect a unique wavelength band and as the object has been scanned over all lines, an image with spectral resolution given by the wavelength bands detected by different lines of the imaging sensor may be formed. In an alternative, a wavelength that is transmitted onto the light-detecting elements is scanned, e.g. by using a tunable filter. The array of light-detecting elements may thus sequentially obtain frames each depicting the object in a specific wavelength band set by the tunable filter.

Using a scanning mode to obtain image data enables obtaining image data with a high spatial and spectral resolution, since each light-detecting element may in principle correspond to an image point in a final image of the object. However, using a scanning mode requires good synchronization between acquiring of frames and a relative movement of an object and the image sensor. Also, if the object moves too fast, a required corresponding frame rate may not be possible to achieve.

Using a snapshot mode to gather image data in three dimensions in a single exposure is fast and thus allows imaging a fast-moving object. However, the snapshot mode requires assigning light-detecting elements to specific wavelengths which implies that a spatial and/or spectral resolution will be decreased.

Thus, set-up of an image sensor may be designed based on an acceptable compromise between speed of acquiring an image, spatial resolution and spectral resolution.

### Summary of the Invention

An objective of the present inventive concept is to provide an improved image sensor. It is a particular objective of the present inventive concept to provide an image sensor which may allow acquiring images with a high speed while providing a good spatial and spectral resolution.

These and other objectives of the present inventive concept are at least partially met by the invention as defined in the independent claims. Preferred embodiments are set out in the dependent claims.

According to a first aspect, there is provided an image sensor for spectral imaging, said image sensor comprising: an array of light-detecting elements arranged in rows and columns; and at least one filter arrangement being arranged on the array for defining a plurality of separate sensor blocks of the array; wherein the plurality of sensor blocks comprise at least: a first mosaic block associated with a first mosaic filter of the at least one filter arrangement, said first mosaic block comprising a first plurality of rows of the array, wherein the first mosaic block is divided into sub-groups of light-detecting elements, wherein each sub-group extends across at least two rows and at least two columns and the first mosaic filter is arranged to transmit a plurality of unique wavelength bands to the light-detecting elements within the sub-group, wherein one wavelength band is transmitted to each light-detecting element, wherein one or more of the sub-groups are repeated across the rows and columns of the array of the first mosaic block such that the light-detecting elements of the first mosaic block are arranged to acquire a first sub-image in two spatial dimensions, wherein image points in the first sub-image has a spectral resolution defined by the unique wavelength bands in each sub-group; and a second block comprising a second plurality of rows of the array, wherein each light-detecting element of the second block is arranged to detect light of a common wavelength band such that the light-detecting elements of the second block are arranged to acquire a second sub-image in two spatial dimensions wherein each image point in the second sub-image corresponds to a single light-detecting element in the array.

Thanks to the invention, a plurality of sensor blocks, i.e. at least two sensor blocks, is defined. Each of the sensor blocks allows acquiring a sub-image of an object, wherein the sub-image forms a snapshot of the object with specific characteristics defined by the sensor block. Each sub-image may thus provide information in two spatial dimensions of the object.

A series of snapshots (sub-images) of the object may be acquired by the sensor blocks such that the sub-images may be combined to form an image of the object with different spectral information being acquired in different sub-images. Since each of the sensor blocks may image an object in two dimensions, the image sensor need not be ready to acquire a new frame each time an object is moved a distance corresponding to a size of the light-detecting elements. Thus, a requirement on frame rate of the image sensor is not very high and the image sensor is thus able to image objects that are moving relatively fast in relation to the image sensor.

The sensor blocks may be adapted to spectral information and/or spatial resolution that is desired to be acquired by the image sensor. Thus, the sensor blocks included in the image sensor may be chosen during manufacture to be adapted to a specific set-up or for acquiring a specific combination of information. For instance, the first mosaic block may provide desired spectral information and may be combined with a second block for providing complementary spectral and/or spatial information. It should be realized that different combinations of sensor blocks may be used and although a number of specific combinations are described herein, other combinations may be used as well.

The second block may provide a higher spatial resolution than the first block such that the combined image may provide spatial information corresponding to a maximum spatial resolution defined by a density of the light-detecting elements of the array. The first block may be arranged to provide a desired spectral resolution by including desired wavelength bands in the sub-groups.

By defining a plurality of sensor blocks in a common array of light-detecting elements, the image sensor is also able to acquire different sub-images of an object that are well-aligned. For instance, the object has to move a very short distance in relation to the image sensor in order to be imaged by the plurality of sensor blocks (as the sensor blocks are arranged in the same array). Also, the first plurality of rows is aligned with the second plurality of rows by the arrangement of both pluralities of rows within the same array.

Also, the sensor blocks are arranged in the same focal plane defined by a common optical system for guiding light from the object towards the image sensor. This implies that the sensor blocks may image the object in a similar manner.

The information acquired by the different sensor blocks may thus be acquired in a very similar manner in relation to the object, which facilitates combination of the sub-images into a combined image.

The array of light-detecting elements may be arranged in an ordered structure, wherein columns and rows are arranged at equal distances between adjacent columns and between adjacent rows and with a common size of the light-detecting elements throughout the array. The array may be rectangular in that each column extends over all rows and each row extends over all columns.

The array of light-detecting elements may be easy to manufacture and may be a conventional array of light-detecting elements which may be manufactured in mass production. A mass-produced chip containing the array of light-detecting elements may thus later be provided with a filter arrangement for defining the sensor blocks within the array.

The at least one filter arrangement is arranged to define the plurality of sensor blocks. Each sensor block may be provided with its own filter arrangement for defining the wavelength bands that are transmitted to the respective light-detecting elements. It should also be realized that a filter arrangement may be arranged on a first plurality of rows of the array for defining a first block, wherein the filter arrangement may also define a second block as the rows of the array not covered by the filter arrangement. Thus, each sensor block is not necessarily associated with a respective filter arrangement.

The first mosaic filter may be arranged in a number of different manners for defining the wavelength bands being detected by the light-detecting elements in the first plurality of rows of the array.

In an embodiment, the first mosaic filter may be arranged to transmit a unique wavelength band to each light-detecting element within a sub-group. However, two or more light-detecting elements may be arranged to detect a common wavelength band, such that the number of unique wavelength bands detected within a sub-group does not necessarily equal the number of light-detecting elements in the sub-group. For instance, if the light-detecting elements have a lower sensitivity to light of a specific wavelength, the mosaic filter may transmit the specific wavelength to at least two light-detecting elements in the sub-group.

In an embodiment, the sub-groups of light-detecting elements may be identical and repeated across the rows and columns of the array of the mosaic block. This implies that each image point in the sub-image acquired by the mosaic block has an identical spectral resolution defined by wavelength bands detected in each sub-group. However, it should be realized that all sub-groups in the mosaic block need not be identical. For instance, a plurality of different settings of the sub-groups may be defined, wherein the different sub-groups may be arranged with different combinations of unique wavelength bands and number of light-detecting elements per wavelength band. Thus, one such sub-group of light-detecting elements with a specific setting may be repeated across the rows and columns of the mosaic block. However, several sub-groups with different settings may also be repeated across the rows and columns of the mosaic block.

According to an embodiment, the second block is a panchromatic sensor block and wherein each light-detecting element of the second block is arranged to detect light of a common wavelength band defined by sensitivity of the light-detecting elements.

The panchromatic sensor block may be defined by the at least one filter arrangement by the panchromatic sensor block being provided with no wavelength filter. Thus, each light-detecting element in the panchromatic sensor block may detect light within a sensitivity range of the light-detecting element without distinguishing which wavelength is detected.

The panchromatic sensor block allows imaging an overall intensity of light with a high spatial resolution, which may be advantageously combined with the spectral resolution provided by the mosaic block.

The panchromatic sensor block could be provided with a neutral density filter in order to prevent the light-detecting elements of the second plurality of rows to be saturated and thus balance a signal from the second block to signals detected in the first block and in other blocks.

According to an embodiment, the plurality of sensor blocks comprise a further mosaic block associated with a further mosaic filter of the filter arrangement, said further mosaic block comprising a third plurality of rows of the array, wherein the further mosaic block is divided into sub-groups of light-detecting elements, wherein each sub-group extends across at least two rows and at least two columns and the further mosaic filter is arranged to transmit a plurality of unique wavelength bands to the light-detecting elements within the sub-group, wherein one wavelength band is transmitted to each light-detecting element, wherein one or more of the sub-groups are repeated across the rows and columns of the array of the further mosaic block such that the light-detecting elements of the further mosaic block are arranged to acquire a third sub-image in two spatial dimensions, wherein image points in the third sub-image has a spectral resolution defined by the unique wavelength bands in each sub-group, wherein the first mosaic filter is arranged to transmit unique wavelength bands within a first wavelength range to each light-detecting element within the sub-group of the first mosaic block and wherein the further mosaic filter is arranged to transmit unique wavelength bands within a second wavelength range to each light-detecting element within the sub-group of the further mosaic block, wherein the first wavelength range is different from the second wavelength range.

The plurality of sensor blocks may thus comprise at least two different mosaic blocks. The arrangement of spectral filters in mosaic blocks may be based on a total number of spectral filters desired, the spatial resolution desired and the wavelength bands of the spectral filters.

For instance, it may be desired to acquire an image with 32 different spectral wavelength bands. If all wavelength bands are arranged in a common mosaic block, e.g. 4x8 light-detecting elements may be arranged in a single sub-group, such that an image point in the sub-image may be formed by 4x8 light-detecting elements. Clearly, with such a configuration, a spatial resolution of the sub-image suffers substantially. By instead using a plurality of mosaic blocks, the sub-groups in each mosaic block may be smaller and, hence, the spatial resolution of the sub-images will be better. For instance, the 32 different spectral wavelength bands could be divided into 4x4 wavelength bands in the sub-groups of a first mosaic block and another 4x4 wavelength bands in the sub-groups of a further mosaic block.

If the unique wavelength bands within a sub-group are very different, the required number of layers, thicknesses of layers and/or materials in the layers of the filter portions (e.g. if the filter portions are provided as Fabry-Perot interference filters) above respective light-detecting elements may differ substantially. Thus, it may be difficult to arrange a mosaic filter to transmit the different wavelength bands to adjacent light-detecting elements. Therefore, the mosaic filters of each mosaic block may be arranged to transmit wavelength bands which are relatively close to each other to the light-detecting elements within a sub-group. Hence, if it is desired to detect wavelength bands that differ substantially, it may be advantageous to distribute the spectral filters for the wavelength bands to different sub-groups arranged in different mosaic blocks. For example, a first mosaic filter may be arranged to transmit wavelength bands in a range of 400-700 nm to the light-detecting elements in a sub-group of a first mosaic block, whereas a further mosaic filter may be arranged to transmit wavelength bands in a range of 600-900 nm to the light-detecting elements in a sub-group of a further mosaic block.

It should be realized that the plurality of sensor block need not be restricted to one or two mosaic blocks, but may comprise three or more mosaic blocks depending on the desired information to be acquired.

According to an embodiment, the plurality of sensor blocks comprise at least a block for non-visible radiation associated with a filter for non-visible radiation of the filter arrangement, wherein the block for non-visible radiation comprises a fourth plurality of rows of the array, wherein each light-detecting element of the block for non-visible radiation is arranged to detect light of a wavelength range outside a visible range such that the light-detecting elements of the block for non-visible radiation are arranged to acquire a fourth sub-image in two spatial dimensions wherein each image point in the fourth sub-image corresponds to a single light-detecting element in the array.

The block for non-visible radiation may thus provide complementary information of the object in addition to spectral information that may be acquired by the first and second blocks. The wavelength range information outside a visible range may add to information of visible wavelengths that may be acquired by the first and/or second blocks.

The block for non-visible radiation may in one embodiment be arranged to detect light of a near infrared wavelength range. The block for non-visible radiation may in another embodiment be arranged to detect light of an ultraviolet wavelength range. Thus, it should be understood that different types of non-visible wavelength ranges may be detected by the block. However, for simplicity, the block for non-visible radiation will below be referred to as a NIR block (detecting light of a near infrared wavelength range).

According to another embodiment, the second block may be arranged as a NIR block. In such case, the first mosaic block may acquire spectral information of unique wavelength bands, e.g. in a visible wavelength range, which may be complemented by near infrared wavelength information of a higher spatial resolution.

According to yet another embodiment, a NIR block may be arranged to acquire a sub-image by binning of light intensity information from a plurality of light-detecting elements. As light-detecting elements may not be very sensitive to near infrared wavelengths, binning of the detected intensities in a plurality of light-detecting elements may be used to increase a detected signal of the near infrared wavelength. This implies that the spatial resolution of the sub-image acquired by the NIR block will not correspond to a single light-detecting element in the array, but rather to the number of light-detecting elements used in binning of detected intensities.

According to another embodiment, the plurality of sensor blocks comprise at least a RGB block associated with a RGB filter of the filter arrangement, wherein the RGB block comprises a fifth plurality of rows of the array, wherein the light-detecting elements of the RGB block are arranged to detect red, green or blue light, respectively, such that the light-detecting elements of the RGB block are arranged to acquire a fifth sub-image in two spatial dimensions wherein each image point in the fifth sub-image comprises three spectral components corresponding to red, green and blue light.

The RGB block may provide a color image matched to human color vision, such that the red, green and blue light filters may be relatively wideband filters providing complementary spectral information fitting for presenting a color image to a human viewer. The RGB filter may thus be arranged e.g. in a Bayer pattern, wherein twice as many light-detecting elements are arranged to detect green light compare to the number of light-detecting elements arranged to detect blue and red light, respectively.

According to an embodiment, the image sensor further comprises an image processor, which is arranged to receive a plurality of frames acquired by the plurality of sensor blocks, wherein each frame comprises a plurality of sub-images acquired by the plurality of sensor blocks, wherein the image processor is arranged to combine a first sub-image from a first frame with a second sub-image from a second frame depicting a common object so as to form a combined image of improved spatial and/or spectral resolution.

Hence, the sub-images acquired by the sensor blocks may complement each other in the forming of a combined image. Since each sensor block images the object in two spatial dimensions, the sub-images need not be acquired with a well-controlled synchronization of frame rate to a relative movement of the object and the image sensor. Rather, the image processor may be arranged to determine image points in a first sub-image that correspond to image points in a second sub-image (in that the image points of the respective sub-images depict a same portion of the object). A knowledge of approximate speed of the relative movement of the object and the image sensor may be used in aiding the image processor to quickly determine a relation between the first sub-image and a second sub-image.

The image processor need not necessarily be part of the image sensor, but may instead be an external unit, which is arranged to receive frames from the image sensor and form a combined image. The image processor could thus for example be implemented in an external computer, which may be arranged to communicate with the image sensor through a wired or wireless communication for receiving frames from the image sensor.

According to an embodiment, the image sensor further comprises a plurality of rejection filters associated with respective sensor blocks, wherein the rejection filters are adapted to balance light intensity such that light-detecting elements throughout the array receive light intensities in same order of magnitude.

The plurality of rejection filters may be arranged on the respective sensor blocks and may thus be mounted on a surface on which the array of light-detecting elements is arranged. The use of rejection filters may control intensity of light reaching the light-detecting elements. The rejection filters may e.g. ensure that a signal-to-noise ratio (SNR) and/or dynamic range is similar for the respective sensor blocks.

The use of rejection filters could be especially useful when the light intensities of wavelengths detected by different sensor blocks differ substantially or when the sensitivity of the light-detecting elements to the detected wavelengths differ substantially. For instance, a panchromatic sensor block may receive relatively high intensities of light and may therefore need a rejection filter in order to prevent saturation of the light-detecting elements in the sensor block. Also, light-detecting elements of a NIR block may have a relatively low sensitivity to the received light and may therefore need higher light intensities than other sensor blocks in order for the SNR and/or dynamic range of the NIR block to be similar to other sensor blocks. This may be achieved by arranging rejection filters on other sensor blocks.

A rejection filter associated with a sensor block may also be arranged to block (e.g. absorb or reflect) light of undesired wavelengths to reach the filter arrangement associated with the sensor block. Thus, the filter arrangement may be arranged to transmit a particular wavelength band to light-detecting elements within a wavelength range set by the rejection filter. For instance, if an interference filter is used, the filter arrangement may not be able to separate wavelengths that differ by a factor two (such as 400nm and 800nm). This separation may instead be achieved by the rejection filter.

According to a second aspect, there is provided an imaging device comprising: an image sensor according to the first aspect; and an optical system for forming an image onto an image plane in which the image sensor may be mounted.

Effects and features of this second aspect are largely analogous to those described above in connection with the first aspect. Embodiments mentioned in relation to the first aspect are largely compatible with the second aspect.

According to a third aspect, there is provided an imaging system comprising: the imaging device according to the second aspect; and a movable carrier; wherein the image sensor is mounted on the movable carrier and the carrier is arranged to move in relation to an object such that the image sensor is arranged to acquire a plurality of frames depicting the object while the carrier moves in relation to the object, so that the object is depicted on different sensor blocks of the image sensor in different frames.

Effects and features of this third aspect are largely analogous to those described above in connection with the first and second aspects. Embodiments mentioned in relation to the first and second aspects are largely compatible with the third aspect.

The imaging device may thus make use of the imaging sensor in order to enable acquiring sub-images such that a combined image with improved spatial and spectral resolution may be formed.

The imaging system may include a carrier for moving the image sensor in relation to the object, which implies that the desired information may be obtained and that the sub-images may be combined to provide rich spectral information for each image point depicting the object. Thus, the imaging system may itself provide the relative movement to the object.

The imaging system could for instance comprise a drone, which may provide a movable carrier in the form of a flying vehicle.

According to an embodiment, the imaging system further comprises a controller for controlling a frame rate at which frames are acquired by the image sensor in relation to a speed of movement of the movable carrier.

Thus, the frame rate may be controlled and adapted to the speed of movement. The controller could receive information of a speed of movement of the movable carrier through sensor information or may itself also control the speed of movement of the movable carrier by controlling a driver which drives a movement of the carrier.

According to an embodiment, the frame rate is controlled such that at least two frames are acquired during a time which the object is moved a distance on the image sensor corresponding to the number of rows within a sensor block. This implies that a part of the object is imaged at least in two sub-images acquired in subsequent frames by the sensor block, which ensures that the sensor block will image the entire object.

According to a fourth aspect, there is provided a method for spectral imaging, said method comprising: acquiring a first frame with an image sensor comprising an array of light-detecting elements arranged in rows and columns, said first frame comprising a first sub-image depicting an object acquired by a first sensor block of the array, wherein the first sensor block comprises a first plurality of rows and wherein the light-detecting elements of the first sensor block are arranged to detect light of a first wavelength band; acquiring a second frame after the image sensor and the object are moved in relation to each other, wherein the second frame is acquired with the array of light-detecting elements arranged in rows and columns, said second frame comprising a second sub-image depicting the object acquired by a second sensor block of the array, wherein the second sensor block comprises a second plurality of rows and wherein the light-detecting elements of the second sensor block are arranged to detect light of a second wavelength band.

Effects and features of this fourth aspect are largely analogous to those described above in connection with the first, second, and third aspects. Embodiments mentioned in relation to the first, second, and third aspects are largely compatible with the fourth aspect.

The method for spectral imaging enables acquiring of complementary information by means of a first and second sensor block arranged in the same array of light-detecting elements. Each sub-image provides information in two dimensions of the object, such that the spectral information of the sub-images may be directly combined for forming spectral information in two spatial dimensions of the object. The method may thus enable acquiring information for a fast-moving object, as the requirements on frame rate and synchronization of the frame rate to a relative movement of the object and the image sensor are not very harsh.

According to an embodiment, the first sensor block is a first mosaic block associated with a first mosaic filter, wherein the first mosaic block is divided into sub-groups of light-detecting elements, wherein each sub-group extends across at least two rows and at least two columns and the first mosaic filter is arranged to transmit a plurality of unique wavelength bands to the light-detecting element within the sub-group, wherein one wavelength band is transmitted to each light-detecting element, wherein one or more of the sub-groups are repeated across the rows and columns of the array of the first mosaic block such that the light-detecting elements of the first mosaic block are arranged to acquire the first sub-image in two spatial dimensions, wherein image point in the first sub-image has a spectral resolution defined by the unique wavelength bands in each sub-group; and wherein the second sensor block is a further mosaic block associated with a further mosaic filter, wherein the further mosaic block is divided into sub-groups of light-detecting elements, wherein each sub-group extends across at least two rows and at least two columns and the further mosaic filter is arranged to transmit a plurality of unique wavelength bands to each light-detecting element within the sub-group, wherein one wavelength band is transmitted to each light-detecting element, wherein one or more of the sub-groups are repeated across the rows and columns of the array of the further mosaic block such that the light-detecting elements of the further mosaic block are arranged to acquire the second sub-image in two spatial dimensions, wherein image points in the second sub-image has a spectral resolution defined by the unique wavelength bands in each sub-group, wherein the first mosaic filter is arranged to transmit unique wavelength bands within a first wavelength range to each light-detecting element within the sub-group of the first mosaic block and wherein the further mosaic filter is arranged to transmit unique wavelength bands within a second wavelength range to each light-detecting element within the sub-group of the further mosaic block, wherein the first wavelength range is different from the second wavelength range.

The first and second sensor blocks may thus be arranged to acquire complementary spectral information from a first and a second wavelength range such that a high spectral resolution may be acquired from the two sensor blocks while still a high spatial resolution may be acquired.

According to an embodiment, the method further comprises acquiring a third frame after the image sensor and the object are moved in relation to each other, wherein the third frame is acquired with the array of light-detecting elements arranged in rows and columns, said third frame comprising a third sub-image depicting the object acquired by a third sensor block of the array, wherein the third sensor block comprises a third plurality of rows and wherein each light-detecting element of the third block is arranged to detect light of a common wavelength band such that the light-detecting elements of the third block are arranged to acquire the third sub-image in two spatial dimensions wherein each image point in the third sub-image corresponds to a single light-detecting element in the array.

Thus, the method may comprise acquiring information from a plurality of sensor blocks, which may together gather large amounts of information of an object. The third sensor block may be used in combination with the first mosaic block and the further mosaic block to provide a high spatial resolution of the object, which may be combined with the spectral resolution from the first mosaic block and the further mosaic block.

According to an embodiment, the method further comprises combining the first sub-image depicting the object with the second sub-image depicting the object so as to form a combined image of improved spatial and/or spectral resolution.

According to an embodiment, the image sensor is arranged on a movable carrier, and the method further comprises moving the movable carrier in relation to the object between acquiring of frames.

It should be realized that the object may instead be moved and the image sensor may be stationary, so that the movement of the object may enable acquiring of a plurality of frames with the object being imaged by different sensor blocks in different frames. For instance, the image sensor may be stationary arranged above a transport belt to image objects moving on the transport belt.

### Brief Description of Drawings

The above, as well as additional objects, features and advantages of the present inventive concept, will be better understood through the following illustrative and non-limiting detailed description of preferred embodiments of the present inventive concept, with reference to the appended drawings. In the drawings like reference numerals will be used for like elements unless stated otherwise.
Fig. 1 is a schematic view of an image sensor according to an embodiment.
Fig. 2 is a schematic view of a sensor block with mosaic configuration in the image sensor.
Fig. 3 is a schematic view of a plurality of sensor blocks associated with rejection filters.
Fig. 4 is a schematic view of an imaging device including an image sensor according to an embodiment.
Fig. 5 is a schematic view of an imaging system comprising a movable carrier.
Fig. 6 is a flowchart of a method according to an embodiment.

### Detailed Description

Detailed embodiments of the present invention will now be described with reference to the drawings.

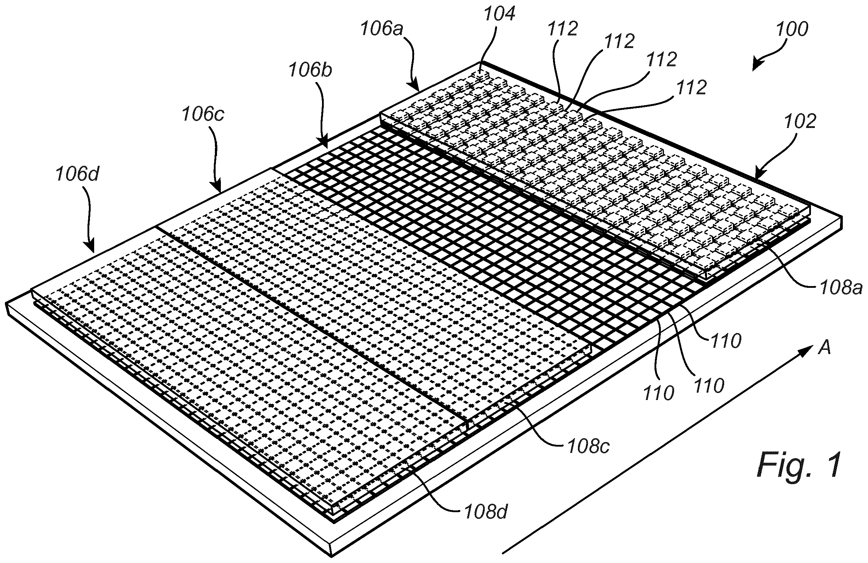

Referring now to Fig. 1, an image sensor 100 will be described. The image sensor 100 may be used for acquiring an image of an object with high spatial and spectral resolution.

The image sensor 100 may be based on a complementary metal-oxide-semiconductor (CMOS) structure. The CMOS structure may comprise an array 102 of light-detecting elements 104 and may further comprise circuitry e.g. for reading out detected light intensities in the light-detecting elements 104 and for timing accumulation of light in the light-detecting elements. The CMOS structure may also comprise circuitry for processing the detected light intensities, such as analog-to-digital converters (ADC) and/or other processing components. The CMOS structure may thus provide a possibility of detecting light intensities and outputting an image representation, e.g. in the form of digital values of the light intensities detected by each light-detecting element 104 in the array 102.

The light-detecting elements 104 may be arranged to accumulate charges in dependence of light incident on the light-detecting element 104. The light-detecting element 104 may thus comprise e.g. a photodiode or a photo-transistor.

The array 102 may comprise identical light-detecting elements 104 which are arranged in rows and columns in order to form a two-dimensional array 102. The CMOS structure comprising the array 102 may thus be relatively simple and may also be useful for a number of different applications. This implies that chips carrying the array 102 with an associated read-out and control circuitry may be manufactured in large volumes and may therefore be very cheap. Thus, the image sensor 100 may advantageously be formed based on a mass-manufactured CMOS structure.

The array 102 with associated circuitry may be formed on a substrate, wherein desired functionality of the CMOS structure may be achieved by forming a plurality of layers on the substrate. A thickness of the substrate may then be reduced, such that illumination may fall on the light-detecting elements 104 through the substrate, so-called backside illumination. This implies that the light will not need to pass layers arranged on the CMOS structure e.g. for readout and, hence, losses of light due to reflections or absorptions in such layers may be avoided. Thus, backside illumination may provide a possibility to detect as much light as possible, enabling imaging with a high quality.

The image sensor 100 may comprise a plurality of sensor blocks 106a-d, which may be adapted for acquiring sub-images with different spectral and/or spatial resolutions. The image sensor 100 may be arranged to move in relation to an object (by the object moving, by the image sensor 100 being arranged on a moving carrier or by both the object and the image sensor 100 moving). The object will thus be scanned over an area of the image sensor 100 as indicated by arrow A identifying a scanning direction. During movement of the object in relation to the image sensor, a number of frames may be acquired, wherein the sub-images of the sensor blocks 106a-d in different frames will depict the same part of the objects. Thus, the combination of sub-images acquired by different sensor blocks 106a-b may form an image with high spatial and spectral resolution using a fact that different information is gathered by different sensor blocks 106a-d.

The image sensor 100 may comprise at least one filter arrangement 108a-d for defining the plurality of sensor blocks 106a-d. As illustrated in Fig. 1, filter arrangements 108a, 108c, 108d are arranged above a first, third and fourth sensor block 106a, 106c, 106d. No filter arrangement is present above the second sensor block 106b, which may then be defined by absence of a filter arrangement between the filter arrangements 108a, 108c. Thus, it should be realized that it is not necessary that the image sensor 100 comprises as many filter arrangements 108 as sensor blocks 106.

Each sensor block 106 may comprise a plurality of rows 110 of the array 102. The sensor block 106 may thus acquire a sub-image in two spatial dimensions of an object in a single frame. The sensor blocks 106 may be of similar size and the image sensor 100 may typically comprise two to six sensor blocks 106. An array 102 of light-detecting elements may typically comprise 1000 rows 110 or more, which implies that each sensor block 106 could comprise more than 150 rows of the array 102 and even more if the array 102 is divided into only a few, such as two, sensor blocks 106.

This implies that each sensor block 106 may be arranged to acquire a sub-image extending in a substantial area defined by a large number of rows 110. The array 102 may further comprise a large number of columns 112 of light-detecting elements 104 and each sensor block 106 may extend across all columns 112.

Thus, a sub-image acquired in one frame (a single exposure) by a sensor block 106 may depict a substantial portion of an object. The object may thus be moved a relatively large distance before another frame needs to be acquired in order for the sensor block 106 to be able to acquire a sequence of sub-images that together may depict an entire object.

In some embodiments, the entire object of interest may fit to be depicted in a single sub-image and the sub-images acquired by different sensor blocks 106a-d may then be combined to form a combined image with high spatial and spectral resolution of the object. Thus, the number of frames required to form the combined image may equal the number of sensor blocks 106 of the array 102.

The filter arrangement(s) 108a-d may be formed on the array 102 to define the plurality of sensor blocks 106. The filter arrangement(s) 108a-d may be provided after the array 102 has been manufactured, which may allow the array 102 of light-detecting elements 104 to be mass-manufactured and the filter arrangement(s) 108a-d may be separately provided on such mass-manufactured (and cheap) arrays 102. The light-detecting elements 104 may thus be identical and may not be specifically adapted to detecting a particular wavelength band.

However, it should be realized that the filter arrangement(s) 108a-d may be arranged on the array 102 in association with manufacture of the array 102. In this regard, light-detecting elements 104 in the array 102 could also have different characteristics in relation to wavelengths to be detected by the respective light-detecting elements 104.

The filter arrangement(s) 108a-d may be arranged directly adjacent to each other, such that each row 110 of the array 102 belongs to a certain sensor block 106. However, it should be realized that it may be difficult to arrange filter arrangement(s) 108 very close to each other, so two adjacent sensor blocks 106 could be separated by one or a few rows 110 of the array 102 (which rows will then not contribute to images acquired by the image sensor 100).

Individual sensor blocks 106 can be optimized for a particular purpose. Each sensor block 106 may thus add extra information that may be included in a combined image. In particular, as illustrated in the example shown in Fig. 1, the sensor blocks 106 may include:
a. A sensor block 106a with a mosaic configuration provides spectral information. The sensor block 106a with mosaic configuration may detect several spectral bands with high specificity.
b. A panchromatic sensor block 106b gives information of an overall light intensity of the image and provide high spatial resolution. The object may thus be imaged in grayscale with high spatial resolution by the panchromatic sensor block 106b. Each image point in a sub-image acquired by the panchromatic sensor block 106b may then correspond to a single light-detecting element 104.
c. A sensor block 106c with a few absorption filters may provide spectral information over broad spectral bands which can e.g. be used to produce true color images. The sensor block 106c may thus for instance be arranged to detect red, blue and green light in broad wavelength bands.
d. Other sensor blocks, such as a NIR block 106d, can be designed with a very high spatial resolution in a single spectral band. It should be realized that the sensor block 106d arranged to detect light of a common, single wavelength band, may be arranged to detect other wavelengths than light in a near infrared wavelength range. For instance, the sensor block 106d may be arranged to detect ultraviolet light, or light of a narrow, or broad, visible wavelength.

It should be realized that other sensor block(s) 106 can add color information with a slightly reduced spatial resolution (by detecting several color wavelength bands within the same sensor block 106).

The combinations of different sensor blocks 106 can take advantage of the specific characteristics of each sensor block 106. Multiple combination of sensor blocks 106 are possible depending on the specific needs of the applications. The image sensor 100 may thus be provided with a combination of sensor blocks 106 adapted to the needs of a specific application. Alternatively, the image sensor 100 may be provided with a relatively large number of sensor blocks 106 which may allow gathering of a large amount of information, such that the information needed for a specific application may be extracted from the available information gathered by the image sensor 100.

Each combination of sensor blocks 106 may present its own advantages. For example:
a. By using a panchromatic sensor block 106b with high resolution and a sensor block 106a with a mosaic configuration it is possible to obtain a high resolution color image by using panchromatic sharpening.
b. A plurality of sensor blocks 106a with different mosaic configurations may be used to detect specific spectral bands and in combination may provide a large number of spectral bands while maintaining a relatively good spatial resolution.

Other examples of the possible combinations are:
c. RGB block 106c and mosaic block 106a.
d. RGB block 106c, mosaic block 106a and NIR block 106d.
e. RGB block 106c, mosaic block 106a, NIR block 106d and panchromatic block 106b.
f. RGB block 106c, mosaic block 106a and panchromatic block 106b.
g. Mosaic block 106a and a UV block.
h. Mosaic block 106a, RGB block 106c and UV block.
i. Different configurations of plural mosaic blocks 106a and panchromatic block 106b.
j. Different configurations of plural mosaic blocks 106a and RGB block 106c.

A skilled person would realize that many other combinations are also possible and may be relevant for different applications.

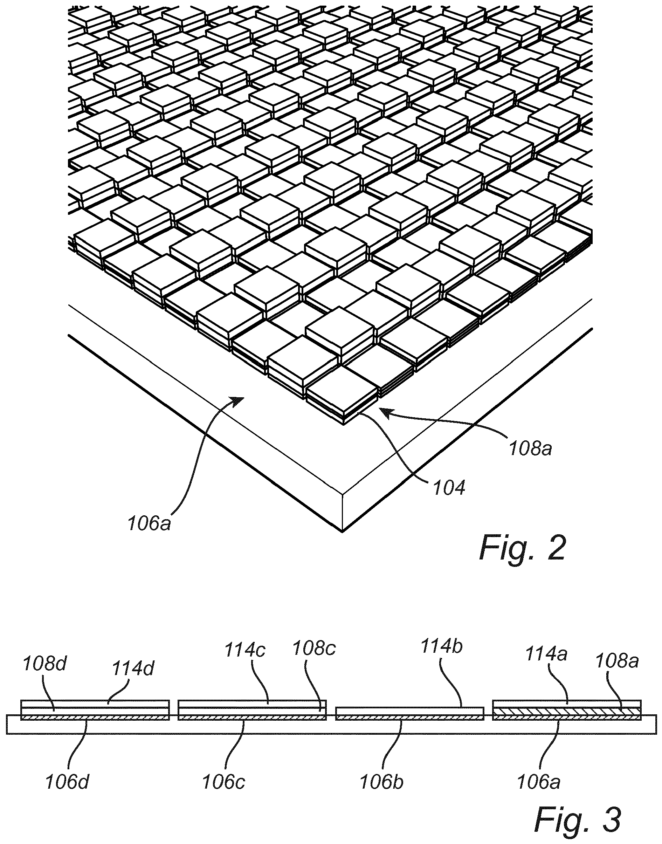

Referring now to Fig. 2, a sensor block 106a with mosaic configuration will be further described and a filter arrangement 108a for providing the mosaic configuration will be described.

A mosaic filter 108a may divide the light-detecting elements 104 of the mosaic block 106a into sub-groups, wherein the mosaic filter 108a is arranged to transmit a plurality of unique wavelengths to the light-detecting elements 104 within the sub-group. Each portion of the mosaic filter 108a associated with a single light-detecting element 104 may be formed as an interference filter, such as a Fabry-Pérot filter, arranged to transmit a narrow wavelength band to the light-detecting element 104. The interference filter may be formed by a number of layers, wherein thickness and material of the layers may define the wavelength being transmitted to the light-detecting element 104 below the interference filter.

A combination of interference filters of the mosaic filter 108a may thus define a sub-group of the light-detecting elements 104 and the combination of portions of the mosaic filter 108a may be repeated across the rows 110 and columns 112 of the array 102 within the sensor block 106a. An image point of a sub-image acquired by the mosaic sensor block 106a may thus have a spectral resolution defined by the unique wavelength bands detected within each sub-group.

The interference filters may be integrated on a substrate providing the array 102 of light-detecting elements 104. The interference filters may be formed by well-controlled depositing and/or etching of layers to form individual filter portions for each light-detecting element 104.

The unique wavelengths detected by a sub-group may be designed in dependence on desired characteristics of the mosaic block 106a. For instance, a sub-group may be arranged to detect a number of unique, narrow wavelength bands. The specific wavelength bands may be designed according to an application of an image sensor 100 or may be generally chosen as a number of narrow wavelength bands within a specific wavelength range.

Each sub-group may comprise a few light-detecting elements 104, such as 2x2 light-detecting elements 104. The size of a sub-group is inversely related to a spatial resolution of the sensor block 106a, so if the number of light-detecting elements 104 is large, many unique wavelength bands may be detected but the spatial resolution will be low. Thus, if information of many unique wavelength bands is desired, a further mosaic sensor block may be arranged on the image sensor 100 instead so that the unique wavelength bands may be shared by two or more mosaic sensor blocks 106a.

The sub-groups in a sensor block 106a may be identical and repeated throughout the sensor block 106a. However, in other embodiments, more than one set-up of sub-groups may be provided in the sensor block 106a. Thus, the wavelength information may differ in different image points of the sub-image acquired by the sensor block 106a. The sensor block 106a may comprise two types of sub-groups that are alternately repeated over the sensor block 106a to provide a relatively large spatial resolution, albeit different wavelength information in different image points. It should be realized that other combinations of different set-ups of sub-groups may be provided in the sensor block 106a and one or more of the sub-groups may be repeated in the sensor block 106a.

Each light-detecting element 104 in a sub-group may be arranged to detect a unique wavelength band. However, in other embodiments, two or more light-detecting elements 104 may be arranged to detect a common wavelength band. Thus, for instance, a wavelength band for which a sensitivity of the light-detecting elements 104 is relatively low may be transmitted to more than one light-detecting element 104 within a sub-group.

The mosaic filter 108a may be arranged to transmit unique wavelengths which are within a relatively narrow wavelength range to the light-detecting elements 104 in the sensor block 106a. If the wavelength bands differ substantially, it may be difficult to provide individual interference filters on each light-detecting element 104, as the number of layers, material, and thickness of layers may need to differ substantially between adjacent interference filters.

The image sensor 100 may be provided with a plurality of mosaic sensor blocks 108a. The number of mosaic sensor blocks 108a to be defined in the array 102 may be chosen depending on the number of wavelength bands to be detected and a spread of the wavelength bands.

Thus, if it is desired to detect four wavelength bands, which are relatively close to each other, such as four wavelength bands within a range of 400-600 nm, a single mosaic sensor block 106a could typically be used. Further, a single sensor block 106a may be useful for up to six or even eight different wavelength bands.

However, if it is desired to detect more than eight wavelength bands, it may be relevant to use two or more mosaic sensor blocks 106a as this would allow maintaining a relatively high spatial resolution for image points in the respective sub-images of the mosaic sensor blocks 106a. The wavelength bands may then be divided between the two or more mosaic sensor blocks 106a such that each mosaic sensor block 106a will detect unique wavelength bands spanning a relatively narrow wavelength range.

It should be realized that the above-described detection of wavelength bands in one or more mosaic sensor blocks 106a should be taken merely as examples. For instance, depending on the application, it may be relevant to detect more than eight wavelength bands within a single mosaic sensor block 106a.

The filter arrangement 108d for a NIR sensor block 106d or any other sensor block arranged to detect a common wavelength range is not separately illustrated in the figures. As will be realized by a person skilled in the art, the filter arrangement 108d may comprise one or more layers which extend across the entire NIR sensor block 106d and which may be arranged to absorb or reflect light of undesired wavelengths so as to transmit only the desired wavelengths to the light-detecting elements 104 of the sensor block 106d. This may be achieved e.g. by choosing appropriate materials for the layer(s) of the filter arrangement 108d.

Also, the filter arrangement 108c for a RGB sensor block 106c is not separately illustrated in the figures. The filter arrangement 108c may implement a Bayer pattern or any other appropriate pattern for transmitting red, green and blue light, respectively, to the light-detecting elements 104 in the RGB sensor block 106c, as is readily understood by a person skilled in the art.

As shown in Fig. 3, the image sensor 100 may further comprise one or more rejection filters 114a-d associated with respective sensor blocks 106a-d. The rejection filters 114a-d may ensure that a light intensity reaching the light-detecting elements 104 is balanced so that a similar response may be received with a common exposure time of the light-detecting elements 104 of all sensor blocks 106a-d. The rejection filters 114a-d may thus ensure that light-detecting elements 104 do not saturate in sensor blocks 106a-d receiving large intensities of light, such as the panchromatic sensor block 106b.

The rejection filters 114a-d may also block undesired wavelenghts in order to aid the filter arrangement 108a-d of the respective sensor block 106a-d in selectively transmitting desired wavelength bands to the light-detecting elements 104.

As mentioned above, the image sensor 100 may further comprise circuitry for reading out detected light intensities in the light-detecting elements 104 and for timing accumulation of light in the light-detecting elements. In addition or alternatively to the use of rejection filters 114, the image sensor 100 may be arranged to control the read-out circuitry and/or accumulation time of the light-detecting elements 104, such that different integration times may be used for light-detecting elements 104 in different sensor blocks 106a-d. This implies that saturation of light-detecting elements 104 may also or alternatively be avoided by separate controlling of the integration times of the sensor blocks 106a-d.

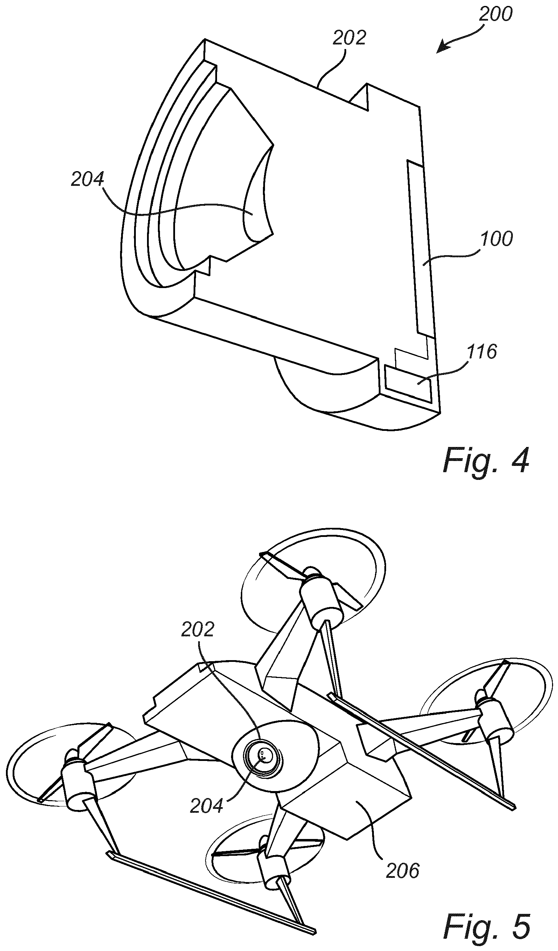

Referring now to Fig. 4, the image sensor 100 may be arranged in an imaging device 200, which may provide a housing 202 in which the image sensor 100 may be mounted. The imaging device 200 may further comprise an optical system 204, which may comprise a plurality of lenses, apertures, filters and other optical components for forming an image onto an image plane in which the image sensor 100 may be mounted.

The housing 202 of the imaging device 200 may define relations between the optical system 204, the image sensor 100 and other components of the imaging device 200. For instance, the rejection filters 114 described above need not necessarily be mounted on the substrate on which the light-detecting elements 104 are formed, but may instead be mounted in the housing 202 of the imaging device 200 to be arranged in an optical path so as to be associated with the respective sensor blocks 106a-d.

The image sensor 100 may comprise an image processor 116, which may be arranged on a common substrate, e.g. a printed circuit board, on which the array 102 of light-detecting elements 104 is mounted. The image sensor 100 may thus provide elements for detecting incident light and also processing circuitry for forming an image representation of the detected light.

However, the image processor 116 may be separately arranged in the imaging device 200, such as being implemented in a central processing unit of the imaging device 200, which may execute operations not only for forming an image representation based on the information acquired by the array 102 of light-detecting elements 104 but may also control other components of the imaging device 200.

The image processor 116 may be implemented in hardware, or as any combination of software and hardware. The image processor 116 may for instance be implemented as software being executed on a general-purpose computer, as firmware arranged e.g. in an embedded system, or as a specifically designed processing unit, such as an Application-Specific Integrated Circuit (ASIC) or a Field-Programmable Gate Array (FPGA).

The image processor 116 may be arranged to receive a sequence of frames from the array 102 of light-detecting elements 104. Each frame may comprise detected light intensities of the light-detecting elements 104 during a common period of time (a single exposure). As mentioned above, however, the integration time may differ for different sensor blocks 106a-d, such that integration may start simultaneously for all light-detecting elements 104 but may be stopped at different times for different sensor blocks 106a-d.

Each frame may thus comprise a plurality of sub-images acquired by the different sensor blocks 106a-d. The image processor 116 may be arranged to extract the sub-images from the frames and may further store the sub-images temporarily in order to enable combining of sub-images from different frames.

The image processor 116 may be arranged to extract a first sub-image acquired by a first sensor block 106a in a first frame. The image processor 116 may further be arranged to extract a second sub-image acquired by a second sensor block 106b in a second frame.

The first and second sub-images may then depict a common object (or common portions of an object) so that the first and second sub-images provide complementary information of the same object. The information of the first and second sub-images may be combined by the image processor 116 for forming a combined image, which may have a high spatial resolution and may comprise a large amount of spectral information for each image point.

The combined image may constitute any type of image representation of information acquired by the image sensor 100, e.g. as an array of image points wherein each image point is associated with a set of information for different spectral bands. The image representation may allow for being displayed on a screen as a multi-color image or for illustrating the information in any other manner.

The image processor 116 may perform image registration operations to compare the first and second sub-images and correlate the information in the sub-images to each other so that information of a common portion of the object is combined. Since the sub-images are acquired using a common array 102, the sub-images should be imaging the object in a similar manner. However, if the relative movement of the object and the image sensor 100 is not parallel to an extension of the columns 112 of the array 102, a common portion of the object may not be depicted in the same columns 112 in the first and second sub-images. This may be handled by the image registration of the image processor 116, which may identify features of the object in the first and second sub-images to correctly correlate the sub-images to each other.

The first and second sub-images are typically not from sequential frames. Rather, a number of frames are acquired during a relative movement of the object and the image sensor 100. The timing of acquiring of the frames need not be exactly synchronized to the relative movement. The frame rate may for instance be set such that at least two frames are acquired during a time which the object is moved a distance on the image sensor 100 corresponding to the number of rows 112 within a sensor block 106. This implies that each part of the object will be imaged by one sensor block 106 in at least two frames and, hence, it is ensured that no part of the object will move past an entire sensor block 106 without being imaged in a sub-image acquired by the sensor block 106.

It should be realized that the frame rate could be even slower in relation to the relative movement while still the sensor blocks 106 being able to image each part of the object. Also, the frame rate could be higher and information of sub-images acquired by the same sensor block 106 in different frames could be combined, e.g. averaged, in order to improve the information of the object acquired by the sensor block 106.

Further, the frame rate need not be varied with varying relative movement speeds of the object and the image sensor 100. Rather, a constant, default frame rate could be used, which may handle a maximum relative movement speed of the object and the image sensor 100. Then, the default frame rate could be constantly used, regardless of the relative movement speed of the object and the image sensor 100.

The image processor 116 may be arranged to identify the first and second sub-images that depict a common part of the object by comparing sub-images from a number of frames. If the relative movement speed of the object and the image sensor 100 is known, the image processor 116 may use this information as an aid to quickly find the first and second sub-images that depict a common part of the object.

The image processor 116 may combine information from all sensor blocks 106a-d of the image sensor 100. Thus, if three sensor blocks 106a-d are arranged on the array 102, the image processor 116 may further identify a third sub-image acquired by a third sensor block 106c depicting a common part of the object with the first and second sub-images and may combine the information of the first, second and third sub-images.

It should also be realized that a single sub-image acquired by a sensor block 106 may not image all parts of the object that are desired to be included in the combined image. Thus, information of different parts of the object may be acquired in different frames by the same sensor block 106. The sub-images from different frames may then be stitched together to form a larger two-dimensional image. The image processor 116 may analyze a relation of sub-images acquired by the same sensor block 106 in different frames (e.g. by finding distinctive features of the object to determine a position of a common part of the object in two sub-images) in order to enable stitching of the sub-images in a correct manner.

The combined image may thus use a plurality of sub-images from each sensor block 106 in order to enable forming a large image in two spatial dimensions. Also, each image point in the combined image may comprise information from a plurality of sub-images acquired by different sensor blocks 106a-d so as to provide a high spectral resolution.

Referring now to Fig. 5, an imaging system is shown comprising a movable carrier 206 on which the housing 202 may be mounted. Alternatively, the optical system 204 and the image sensor 100 may be directly mounted on the movable carrier 206 forming the imaging device 200 integrated with the movable carrier 206.

The movable carrier 206 may be in the form of a drone as illustrated in Fig. 5. However, the movable carrier 206 may be implemented in many other ways, not only as a flying vehicle, but may rather move on land using wheels or being guided on a rail or may move on water having a floating body.

The movable carrier 206 may be controlled by a controller, e.g. in the form of a processing unit executing a controlling software. The controller may control movement of the movable carrier 206 based on input from a remote unit with which the controller communicates or based on instructions in the controlling software. The controller may also implement the image processor 116 in the same processing unit such that information of movement of the movable carrier 206 may be readily available to the image processor 116 for use in aiding the forming of a combined image.

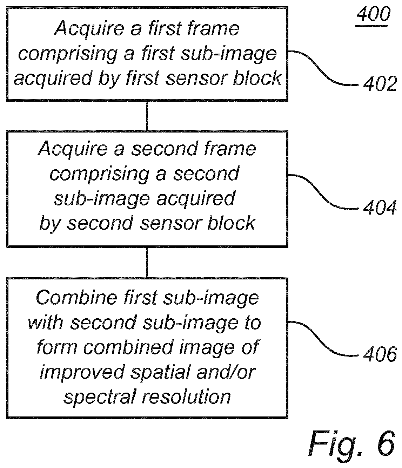

Referring now to Fig. 6, a method 400 for spectral imaging will be briefly summarized in addition to the disclosure provided above in relation to processing performed by the image processor 116.

The method comprises acquiring 402 a first frame with the image sensor 100, wherein the first frame comprises a first sub-image depicting an object and the first sub-image is acquired by the first sensor block 106a of the array 102.

The method further comprises acquiring 404 a second frame after the image sensor 100 and the object are moved in relation to each other, wherein the second frame comprises a second sub-image depicting the object and the second sub-image is acquired by the second sensor block 106b of the array 102.

The method further comprises combining 406 the first sub-image depicting the object with the second sub-image depicting the object so as to form a combined image of improved spatial and/or spectral resolution.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An image sensor for spectral imaging, said image sensor (100) comprising:
an array (102) of light-detecting elements (104) arranged in rows (110) and columns (112); and
at least one filter arrangement (108) being arranged on the array (102) for defining a plurality of separate sensor blocks (106) of the array (102);
wherein the plurality of sensor blocks (106) comprise at least:
a first mosaic block (106a) associated with a first mosaic filter (108a) of the at least one filter arrangement (108), said first mosaic block (106a) comprising a first plurality of rows of the array (102), wherein the first mosaic block (106a) is divided into sub-groups of light-detecting elements (104), wherein each sub-group extends across at least two rows and at least two columns and the first mosaic filter (108a) is arranged to transmit a plurality of unique wavelength bands to the light-detecting elements (104) within the sub-group, wherein one wavelength band is transmitted to each light-detecting element (104), wherein one or more of the sub-groups are repeated across the rows and columns of the array (102) of the first mosaic block (106a) such that the light-detecting elements (104) of the first mosaic block (106a) are arranged to acquire a first sub-image in two spatial dimensions, wherein image points in the first sub-image has a spectral resolution defined by the unique wavelength bands in each sub-group; and
a second block (106b) comprising a second plurality of rows of the array (102), wherein each light-detecting element (104) of the second block (106b) is arranged to detect light of a common wavelength band such that the light-detecting elements (104) of the second block (106b) are arranged to acquire a second sub-image in two spatial dimensions wherein each image point in the second sub-image corresponds to a single light-detecting element (104) in the array (102).

2. The image sensor according to claim 1, wherein the second block (106b) is a panchromatic sensor block and wherein each light-detecting element (104) of the second block (106b) is arranged to detect light of a common wavelength band defined by sensitivity of the light-detecting elements (104).

3. The image sensor according to claim 1 or 2, wherein the plurality of sensor blocks (106) comprise a further mosaic block associated with a further mosaic filter of the filter arrangement (108), said further mosaic block comprising a third plurality of rows of the array (102), wherein the further mosaic block is divided into sub-groups of light-detecting elements (104), wherein each sub-group extends across at least two rows and at least two columns and the further mosaic filter is arranged to transmit a plurality of unique wavelength bands to the light-detecting elements (104) within the sub-group, wherein one wavelength band is transmitted to each light-detecting element (104), wherein one or more of the sub-groups are repeated across the rows and columns of the array (102) of the further mosaic block such that the light-detecting elements (104) of the further mosaic block are arranged to acquire a third sub-image in two spatial dimensions, wherein image points in the third sub-image has a spectral resolution defined by the unique wavelength bands in each sub-group, wherein the first mosaic filter (108a) is arranged to transmit unique wavelength bands within a first wavelength range to each light-detecting element (104) within the sub-group of the first mosaic block (106a) and wherein the further mosaic filter is arranged to transmit unique wavelength bands within a second wavelength range to each light-detecting element within the sub-group of the further mosaic block, wherein the first wavelength range is different from the second wavelength range.

4. The image sensor according to any one of the preceding claims, wherein the plurality of sensor blocks (106) comprise at least a block for non-visible radiation (106d) associated with a filter for non-visible radiation of the filter arrangement (108), wherein the block for non-visible radiation comprises a fourth plurality of rows of the array (102), wherein each light-detecting element (104) of the block for non-visible radiation (106d) is arranged to detect light of a wavelength range outside a visible range such that the light-detecting elements (104) of the block for non-visible radiation (106d) are arranged to acquire a fourth sub-image in two spatial dimensions wherein each image point in the fourth sub-image corresponds to a single light-detecting element (104) in the array (102).

5. The image sensor according to any one of the preceding claims, wherein the plurality of sensor blocks (106) comprise at least a RGB block (106c) associated with a RGB filter of the filter arrangement (108), wherein the RGB block (106c) comprises a fifth plurality of rows of the array (102), wherein the light-detecting elements (104) of the RGB block (106c) are arranged to detect red, green or blue light, respectively, such that the light-detecting elements (104) of the RGB block (106c) are arranged to acquire a fifth sub-image in two spatial dimensions wherein each image point in the fifth sub-image comprises three spectral components corresponding to red, green and blue light.

6. The image sensor according to any one of the preceding claims, further comprising an image processor (116), which is arranged to receive a plurality of frames acquired by the plurality of sensor blocks (106), wherein each frame comprises a plurality of sub-images acquired by the plurality of sensor blocks (106), wherein the image processor (116) is arranged to combine a first sub-image from a first frame with a second sub-image from a second frame depicting a common object so as to form a combined image of improved spatial and/or spectral resolution.

7. The image sensor according to any one of the preceding claims, further comprising a plurality of rejection filters (114) associated with respective sensor blocks (106), wherein the rejection filters (114) are adapted to balance light intensity such that light-detecting elements (104) throughout the array (102) receive light intensities in same order of magnitude.

8. An imaging device comprising:
an image sensor (100) according to any one of the preceding claims; and
an optical system (204) for forming an image onto an image plane in which the image sensor (100) may be mounted.

9. An imaging system, comprising:
the imaging device according to claim 8; and
a movable carrier (206);
wherein the image sensor (100) is mounted on the movable carrier (206) and the carrier (206) is arranged to move in relation to an object such that the image sensor (100) is arranged to acquire a plurality of frames depicting the object while the carrier (206) moves in relation to the object, so that the object is depicted on different sensor blocks (106) of the image sensor (100) in different frames.

10. The imaging system according to claim 9, further comprising a controller for controlling a frame rate at which frames are acquired by the image sensor (100) in relation to a speed of movement of the movable carrier (206).

11. The imaging system according to claim 10, wherein the frame rate is controlled such that at least two frames are acquired during a time which the object is moved a distance on the image sensor (100) corresponding to the number of rows within a sensor block (106).

12. A method for spectral imaging, said method comprising:
acquiring (402) a first frame with an image sensor (100) comprising an array (102) of light-detecting elements (104) arranged in rows (110) and columns (112), said first frame comprising a first sub-image depicting an object acquired by a first sensor block (106a) of the array (102), wherein the first sensor block (106a) comprises a first plurality of rows and wherein the light-detecting elements (104) of the first sensor block (106a) are arranged to detect light of a first wavelength band;
acquiring (404) a second frame after the image sensor (100) and the object are moved in relation to each other, wherein the second frame is acquired with the array (102) of light-detecting elements (104) arranged in rows (110) and columns (112), said second frame comprising a second sub-image depicting the object acquired by a second sensor block (106b) of the array (102), wherein the second sensor block (106b) comprises a second plurality of rows and wherein the light-detecting elements (104) of the second sensor block (106b) are arranged to detect light of a second wavelength band.

13. The method according to claim 11, wherein the first sensor block (106a) is a first mosaic block associated with a first mosaic filter (108a), wherein the first mosaic block is divided into sub-groups of light-detecting elements (104), wherein each sub-group extends across at least two rows and at least two columns and the first mosaic filter (108a) is arranged to transmit a plurality of unique wavelength bands to the light-detecting element (104) within the sub-group, wherein one wavelength band is transmitted to each light-detecting element (104), wherein one or more of the sub-groups are repeated across the rows and columns of the array (102) of the first mosaic block such that the light-detecting elements (104) of the first mosaic block are arranged to acquire the first sub-image in two spatial dimensions, wherein image point in the first sub-image has a spectral resolution defined by the unique wavelength bands in each sub-group; and wherein the second sensor block is a further mosaic block associated with a further mosaic filter, wherein the further mosaic block is divided into sub-groups of light-detecting elements (104), wherein each sub-group extends across at least two rows and at least two columns and the further mosaic filter is arranged to transmit a plurality of unique wavelength bands to each light-detecting element (104) within the sub-group, wherein one wavelength band is transmitted to each light-detecting element (104), wherein one or more of the sub-groups are repeated across the rows and columns of the array (102) of the further mosaic block such that the light-detecting elements (104) of the further mosaic block are arranged to acquire the second sub-image in two spatial dimensions, wherein image points in the second sub-image has a spectral resolution defined by the unique wavelength bands in each sub-group, wherein the first mosaic filter (108a) is arranged to transmit unique wavelength bands within a first wavelength range to each light-detecting element (104) within the sub-group of the first mosaic block and wherein the further mosaic filter is arranged to transmit unique wavelength bands within a second wavelength range to each light-detecting element (104) within the sub-group of the further mosaic block, wherein the first wavelength range is different from the second wavelength range.

14. The method according to claim 11 or 12, further comprising acquiring a third frame after the image sensor (100) and the object are moved in relation to each other, wherein the third frame is acquired with the array (102) of light-detecting elements (104) arranged in rows (110) and columns (112), said third frame comprising a third sub-image depicting the object acquired by a third sensor block of the array (102), wherein the third sensor block comprises a third plurality of rows and wherein each light-detecting element of the third block is arranged to detect light of a common wavelength band such that the light-detecting elements (104) of the third block are arranged to acquire the third sub-image in two spatial dimensions wherein each image point in the third sub-image corresponds to a single light-detecting element (104) in the array (102).

15. The method according to any one of claims 11-14, wherein the image sensor (100) is arranged on a movable carrier (206), further comprising moving the movable carrier in relation to the object between acquiring of frames.
